# EUROPEAN PATENT APPLICATION

(11) **EP 2 393 345 A1**
(43) Date of publication of application: **07.12.2011**
(21) Application number: 10004704.2
(22) Date of filing: 04.05.2010
(51) Int. Cl.: H05K 1/14

(54) **Circuit carrier with recess for receiving electronic components being contacted by a circuit board**

(71) Applicant: Vincotech Holdings S.a.r.l., 2636 Luxembourg (LU)
(72) Inventor: Helbing, Sebastian, 82131 Stockdorf (DE); Koschnick, Frank, 82538 Geretsried (DE); Nothhelfer, Rainer, 82110 Germering (DE); Saric, Dalibor, 81377 München (DE); Frodi, Robert, 81825 München (DE)
(74) Representative: Grünecker, Kinkeldey, Stockmair & Schwanhäusser

(57) **Abstract**

The invention relates to an electronic module package comprised of a circuit carrier and a circuit board, as well as a method for manufacturing the electronic module package. To meet the high demands on portability of modern electronic products, the invention allows to significantly reduce the overall height of such electronic module package by providing a circuit carrier, which on the one hand is used as a fixture for at least one electronic module mounted thereon, and which on the other hand has formed at least one recess at the bottom side thereof. Upon the circuit carrier being mounted on the circuit board, the electronic components of the circuit board are then received by the at least one recess of the circuit carrier, thereby providing a flat shaped electronic module package. The electronic components enclosed by the at least one recess of the circuit carrier remain exclusively contacted by the circuit board at which the circuit carrier is mounted on.

## Description

The invention relates to a circuit carrier comprising at least one recess on one side thereof for receiving electronic components being contacted by a circuit board. The invention further relates to an electronic module package comprised of the circuit carrier having the at least one recess at one side thereof, and the circuit board, as well as a manufacturing method of the electronic module package.

These days, there exists a high demand on increasing the performance of electronic mobile devices, as well as on introducing new features and on increasing functionality thereof. Simultaneously, it is more and more required to increase the portability of modern electronic products by miniaturizing its components.

Generally, there are several techniques known in the prior art to reduce the overall size of such electronic devices. For instance, in order to keep these devices as flat as possible, it is well known to arrange electronic modules, such as antenna modules and receiver modules, on a printed circuit board side by side.

Although this technique allows for a low height of the assembled board, such arrangement then requires a large ground area. In cases it is focused on a reduction of the size of the ground area of an electronic package module, it is known to mount electronic modules on top of each other. In such cases, the top module is often mounted on a fixture also acting a spacer.

However, also the spacer(s) require considerable amounts of space, in particular, with respect to the vertical dimension / height of an assembled module package. Furthermore, such fixtures for electronic modules are expensive and additionally necessitate mounting accessories such as screws, washers, plug-in connectors and extra wiring. Even more, apart from the raised costs due to the need of fixtures for mounting electronic components one upon the other, the weight of the electronic device unfavorably increases due to the implemented fixtures.

Moreover, as a further common technique, electronic modules are also mounted on the top and bottom sides of printed circuit boards. However, manufacturing these double sided printed circuit boards and assembling same as well as mounting the assembled board on a main board, i.e. by soldering, is also very inconvenient and expensive.

In summary, the known techniques for mounting electronic modules so as to form a module package do not satisfy the requirements of reducing the overall size in a convenient and financially competitive manner.

The problem underlying the present invention is to reduce the required space for an electronic module package, to reduce the manufacturing costs and to simplify the mounting and assembling process thereof.

At least one of these objects is solved by the subject matter of the independent claims. Advantageous embodiments of the invention are subject to the dependent claims.

One aspect of the invention is to mount a circuit carrier comprising at least one electronic module on top of a circuit board so as to provide a combined electronic module package, thereby achieving a reduction of the overall mounting area of such module package.

The invention also allows to significantly reduce the overall height of such electronic module package by employing circuit carrier, which on the one hand is used as a fixture for the at least one electronic module (referred to as the at least one second electronic component) mounted thereon (referred to as the first side), and which on the other hand has formed at least one recess at the bottom side (referred to as the second side) thereof.

Upon the circuit carrier being mounted on the circuit board, the electronic components of the circuit board (referred to as the at least one first electronic component) are then received by the at least one recess of the circuit carrier, thereby providing a flat shaped electronic module package. The electronic components enclosed by the at least one recess of the circuit carrier remain exclusively contacted by the circuit board at which the circuit carrier is mounted on.

As the circuit carrier comprising the at least one recess simultaneous serves as a fixture for the electronic modules mounted on top of the circuit carrier, the manufacturing costs for the mounted electronic module package can also be reduced.

In one embodiment of the invention, the at least one recess of the circuit carrier spans substantially the surface of the bottom side of the circuit carrier. Such implementation allows to cover and enclose a wide area of electronic components of on the assembled circuit board mounted below the circuit carrier. The circuit carrier may be a flexible or solid printed circuit board having one layer or a multi-layer structure. One layer may be used for contacting the electronic modules or components mounted thereupon, wherein one ore more of the other layers may comprise the at least one recess.

According to a further embodiment of the invention, the circuit carrier further comprises an electromagnetic shielding element for electromagnetically shielding the electronic components received in the at least one recess upon the circuit carrier being mounted on the circuit board located underneath. By implementing a shielding element at the circuit carrier, additional shielding measures may be obsolete so that the final costs for an electronic module package may be further reduced. Moreover, due to additional shielding elements being not necessary, the space of the module package required when being mounted on a main board may also be reduced.

In a variation, the electromagnetic shielding element is provided at the upper side of the circuit carrier. In another variation, the shielding element may be at one intermediate layer of the multi-layer structure of the circuit carrier. Alternatively, the electromagnetic shielding element may be provided at the bottom surface (inner surface being opposite to the first side of the circuit carrier) of the at least one recess of the circuit carrier. In this configuration, the shielding element itself may further provide a thermal isolation between the electronic modules or components mounted on top of the circuit carrier and the ones located inside the at least one recess after the circuit carrier being mounted on the assembled circuit board.

The electromagnetic shielding element may also be implemented as a planar element for further serving as a ground plane for the electronic component mounted at the upper side of the circuit carrier. Employing the shielding element as ground plane may lead to a further reduction of the required total height of the module package, as no additional ground plane is needed, when for example having an antenna module mounted on the circuit carrier.

In another embodiment of the invention, a thermal isolation of the electronic components received in the at least on recess of the circuit carrier may be provided by the recess itself due to the enclosed electronic components having no contact to the surrounding air of the mounted electronic module package.

According to a further embodiment of the invention, the at least one recess at the bottom side of the circuit carrier is cavity shaped.

In another embodiment of the invention, the circuit carrier is either single or double sided. This implementation allows to mount electronic components at both sides of the circuit carrier, wherein the electronic components of the bottom side of the circuit carrier are mounted inside the at least one recess.

In an additional embodiment of the invention, at least one of the electronic components mounted on top of the circuit carrier may be either a GPS antenna module, an acceleration sensor module, a yaw rate sensor module, or a component for an electronic circuit.

Another embodiment of the invention relates to an electronic module package comprising a circuit carrier according to one of the different embodiments described herein, and a circuit board having mounted the at least one first electronic component. The circuit carrier and the circuit board may be mounted on top of each other, being electrically connected. After mounting the package, the circuit carrier may be located above the bottom circuit board, which comprises the at least one first electronic component. The at least one first electronic component may be received in the at least one recess of the circuit carrier and may be exclusively be contacted by the bottom printed circuit board of the module package.

In a further embodiment of the invention, the electronic module package further may comprise electrical contacts for electrically connecting the electronic module package to a subjacent main printed circuit board.

In another embodiment of the invention, the electrical contacts are realized as a Ball Grid-Array or a Land Grid-Array being provided at the bottom side of the electrical module package.

In a variation, the electrical contacts of the electronic package module are provided on at least one side / edge thereof.

In a further embodiment of the invention, the at least one second electronic component of the circuit carrier is electronically connected to the circuit board at the bottom of the module package by a through connection within the circuit carrier.

According to another embodiment of the invention, the at least one second electronic component is a GPS receiver module.

In an additional embodiment, the invention also relates to a method for manufacturing an electronic module package comprised of a circuit carrier and a circuit board, wherein the circuit board comprises at least one first electronic component being mounted and electrically connected to the circuit carrier. A first side of the circuit carrier may be assembled with at least one second electronic component. At least one recess may be formed at a second side of the circuit carrier, wherein the second side is opposite to the first side. The circuit carrier may be mounted on the circuit board so that the at least one recess of the circuit carrier may receive the at least one first electronic component of the circuit board. Further, the at least one first electronic component remains exclusively contacted by the circuit board located underneath the circuit carrier upon composing the module package.

According to another embodiment of the invention, forming the at least one recess at a second side of the circuit carrier is carried out by either laser shaping, milling or grouting plural pre-punched pre-impregnated fibres during manufacturing of the circuit carrier.

In a further embodiment, an electromagnetic shielding element may be provided at the first side of the circuit carrier or at one intermediate layer of the circuit carrier.

For a better understanding of the present invention, same will be explained in the following based on the embodiments shown in the figures. Corresponding parts are given corresponding reference numerals and terms. Furthermore, those features or combinations of features which show or describe different embodiments may form separate inventive solutions in themselves. The invention will now be described by way of example with reference to the drawings, wherein:
- **Fig. 1**: illustrates a cross-sectional view of an electronic module package mounted on a main printed circuit board according to an exemplary embodiment of the invention;
- **Fig. 2**: illustrates a perspective view of the circuit carrier of the electronic module package comprising a recess formed at the bottom side of the circuit carrier according to an exemplary embodiment of the invention;
- **Fig. 3**: illustrates a perspective view of the circuit carrier of the electronic module package comprising two recesses formed at the bottom side of the circuit carrier according to an exemplary embodiment of the invention;
- **Fig. 4**: illustrates a perspective view of an electronic module package having mounted an antenna module on top of the circuit carrier according to an exemplary embodiment of the invention; and
- **Fig. 5**: illustrates a perspective view of an electronic module package having mounted a sensor module together with further electronic circuit components on top of the circuit carrier according to an exemplary embodiment of the invention.

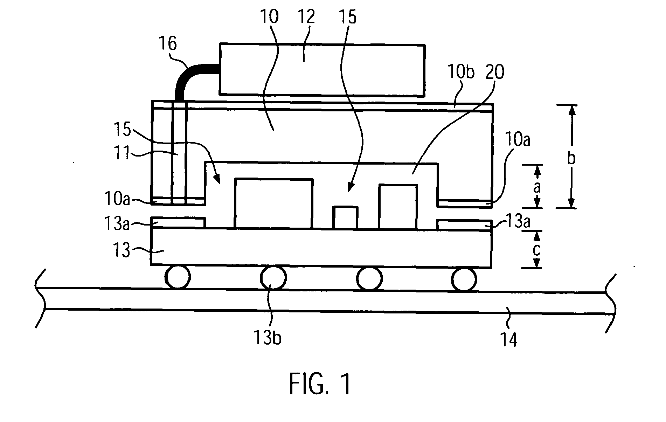

**Fig. 1** shows a cross-sectional view of an electronic module package mounted on a main printed circuit board 14 according to an exemplary embodiment of the invention. For instance such electronic module package may be implemented in a handheld navigation system device.

The electronic module package comprises a circuit carrier 10 having mounted at least one second electronic component 12. Thereby, the at least one second electronic component 12 may be soldered on the surface of the circuit carrier 10. Alternatively, the at least one second electronic component 12 may also be fixed on the top surface of the circuit carrier 10 by using a wire glue.

The second electronic component 12 may be an antenna module such as a GPS patch antenna or the like being realized as an SMD component. The second electronic component 12 may alternatively be a sensor module, i.e. gyro sensor module or yaw sensor module.

The circuit carrier 10 may be a printed circuit board, which is either solid or flexible. For instance, the circuit carrier 10 may be a ceramic printed circuit board or made of resin.

The circuit carrier 10 may comprise a one- or a multi-layer structure. It further comprises at least one recess 20 formed at the bottom side thereof. According to the invention, the at least one recess 20 is an opening of one side / surface of the circuit carrier 10. Thereby, the opening does not span from one the bottom side of the circuit carrier 10 to the upper side of the circuit carrier 10. The at least one recess 20 is located opposite to that side of the circuit carrier 10, at which the at least one second electronic component 12 is mounted on.

The at least one recess 20 may be cut out of the circuit carrier 10 by laser shaping or milling. As indicated in Fig. 1, the recess 20 may be cut out to a depth as indicated by the distance "a". The total thickness of the circuit carrier 10 is indicated by the distance "b". For instance, the distance "b" may be 2 millimeters, whereas the distance "a" may be 1,2 millimeters. In a further example, the depth of the at least one recess 20 may be half of the total thickness of the circuit carrier 10. As an example, the circuit carrier 10 is designed as a two-layer printed circuit board, wherein, for instance, one full layer is milled so as to provide the at least one recess 20.

Although the circuit carrier may comprise plural recesses, in Fig. 1 only one recess 20 is shown.

In an exemplary embodiment of the invention, the circuit carrier 10 is a multi-layer circuit board, wherein the recess 20 is alternatively provided by grouting plural pre-punched pre-impregnated fibres during manufacturing of the circuit carrier 10. For instance, if the circuit carrier 10 comprises two layers each having the same thickness, the depth of the recess 20 may be half of the total thickness of the circuit carrier 10 after grouting a pre-punched pre-impregnated fibre with a flat fibre having itself no pre-punched recess or cut-outs.

The circuit carrier 10 may additionally be provided with an electromagnetic shielding element 10b at the top side or the bottom side of the circuit carrier 10. In case of the circuit carrier 10 comprising a multi-layer structure, the shielding element may alternatively be provided at one intermediate layer.

In another embodiment, the electromagnetic shielding element 10b is a planar element, which is used as a ground plane for the at least one second electronic component 12 mounted at the circuit carrier 10. In case the ground plane is provided at the top side of circuit carrier 10, the at least one second electronic component 12 may be soldered at the ground plane so as to be mounted on the circuit carrier 10. Employing such ground plane may be advantageous in case the second electronic component 12 being an antenna module. The electromagnetic shielding element 10b may be provided by metalizing the upper surface of the circuit carrier 10, according to a further embodiment of the invention.

As another variation, the circuit carrier 10 with its at least one recess 20 directed downwards to a circuit board 13 may also be exclusively used as an electromagnetic shield as a kind of an EMI measure as well as for shielding thermal disturbances from inside the recess 20 and / or from outside the recess 20.

As illustrated in Fig. 1, the circuit carrier 10 with the at least one second electronic module 12 is mounted on top of the assembled circuit board 13. According to an example, the circuit board 13 may be a printed circuit board, which is either solid or flexible. For instance, the circuit board 13 may be a ceramic printed circuit board or made of resin. The circuit board 13 may, for instance, comprise a 4-layer structure, as commonly used for GPS receiver circuits. The circuit board 13 further comprises electronic components, referred to as at least one first electronic component 15. The at least one first electronic component 15 may for instance be a GPS receiver module, control elements used in combination with the sensor modules mounted on the circuit carrier 10, or other electronic components. The height of these at least first electronic component 15 is preferably equal to or smaller than the distance "a" of the recess 20 of the circuit carrier 10 so that the circuit carrier 10 can be mounted on top of the circuit board 13 without obstruction. In an exemplary embodiment of the invention, the at least one first electronic component 15 has a direct mechanical contact to the bottom surface of the recess 20 of the circuit carrier 10 after mounting the circuit carrier on top of the circuit board 13.

According to another embodiment of the invention, where the circuit carrier 10 is assembled on both sides, i.e. also comprises electronic components (not shown) at the bottom of the recess 20 of the circuit carrier 10, the maximum height of the at least one first electronic component 15 has to be reduced accordingly. Alternatively, distance "a" may be adjusted accordingly, if the height of the at least one first electronic component 15 is not reduced.

With respect to the circuit board 13, it has the thickness "c", which may for instance be the same as the thickness of the part of circuit carrier 10, which is located between the top surface of the circuit carrier 10 and the bottom surface of the recess 20. As an example, the thickness "c" may be 0,8 millimetres.

When the circuit carrier 10 is mounted on the circuit board 13, the at least one first electronic components 15 of the circuit board 13 is then received by the at least one recess 20 of the circuit carrier 10. The electronic components 15 enclosed by the recess 20 (which forms a hollow space after mounting) of the circuit carrier 10 remain exclusively electrically contacted by the circuit board 13. The circuit carrier 10 with its recess 20 is merely pulled over the electronic component(s) of the circuit board 13.

According to one embodiment of the invention as shown in Fig. 1, the circuit carrier 10 comprises a solder location 10a, at which a solder connection is made for connecting the circuit carrier 10 to a solder location 13a of the circuit board 13. In order to provide an electrical connection between the at least one second electronic component 12 of the circuit carrier 10, a through connection 11 is formed within side parts of the circuit carrier 10, at which no recess 20 is formed.

According to an advantageous embodiment of the invention, the solder connection between the circuit carrier 10 and the circuit board 13 may also provide electrical contacts between the at least one first electrical components 12 of the circuit carrier 10 and the at least one second electrical component 15 of the circuit board 13.

Within the through connection 11, a wiring 16 can be provided for electrically coupling the at least one second electronic component 12 to the at least one first electronic component 15 of the circuit board 13.

Upon having mounted the circuit carrier 10 on top of the circuit board 13 as described above and upon the at least one first electronic component 15 is located inside the recess 20, it is achieved to significantly reduce the overall height of the complete module package. As an example, such module package with reduced height may comprise, for instance, a GPS antenna on top of the circuit carrier 10 and a GPS receiver element at the circuit board 13, wherein the at least one first electronic component 15, which is the GPS receiver element of this example, is located inside the recess 20.

As the at least one first and at least one second electronic components 12 and 15, needed for the function of the electronic module package, are mounted on top of each other, advantageously a significant reduction of the overall mounting area of such module package is achieved.

According to another advantageous embodiment of the invention, the at least one recess 20 may provide a thermal isolation for the at least one first electric component 15 enclosed therein. In case of the at least one first electronic component 15 being at least one oscillator module, the thermal isolation inside the recess 20 may advantageously bring about the effect of keeping the temperature at a constant level so that thermal influences outside the module package have no impact on the temperature inside the recess 20. Hence, the electronic module package comprising the circuit carrier 10 and circuit board 13 does not require additional temperature compensation means, which allows for further reducing the resulting size of the module package.

As further illustrated in Fig. 1, the electronic module package advantageously meets the requirement of the surface-mounting technology, as the module package is to be contacted as a surface-mounting device, referred to as an SMD. As shown, the module package can be mounted on another printed circuit board, further referred to as the main printed circuit board 14, by using a solder connection. In order to provide such solder connection, for instance, a Ball-Grid array 13b at the bottom side of the module package (bottom side of the circuit board 13) may be used. Alternatively, also a Land-Grid array may be implemented for providing the solder connection. Even more, the electronic module package may be mounted on the main printed circuit board 14 by side contacts which are provided at the bottom edges of the circuit board 13.

As apparent from the description above, by providing the at least one recess 20 at one side of the circuit carrier 10, the circuit carrier 10 not only serves as a fixture for the at least one second electronic component 12, but also acts as a spacer when being mounted on top of the circuit board 13 assembled with the at least one first electronic component 15.

As described above, the module package can be mounted on the main printed circuit board 14 by employing the surface-mounting technology. However, also the circuit carrier 10 and the circuit board 13 can be assembled by using the surface-mounting technology. Even more, the mounting of assembled circuit carrier 10 and circuit board 13 can be manufactured on an SMD mounting line.

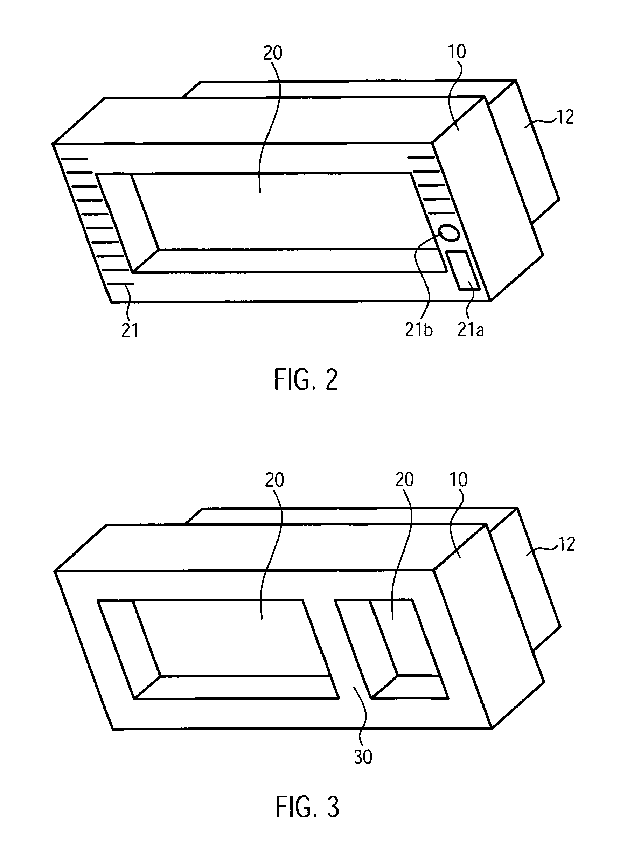

**Fig. 2** illustrates a perspective view of the circuit carrier 10 of the electronic module package comprising the recess 20 formed at the bottom side of the circuit carrier 10 according to an exemplary embodiment of the invention.

In this figure, it is shown that only one recess 20 is provided at the bottom side of the circuit carrier 10. In order to fix the circuit carrier 10 on the bottom printed circuit board 13, several soldering contacts are provided. This may for example be either several pins 21, or at least one square shaped soldering contact 21 a, or at least one round shaped soldering contact 21 b. In a variation of this embodiment, the entire surface of the bottom side of the circuit carrier 10 may be one planar soldering surface.

According to a further advantageous embodiment of the invention, at least one of the soldering contacts 21, 21 a or 21 b may further be contacted with the trough connection 11 of the circuit carrier 10.

In another advantageous embodiment of the invention, the at least one recess 20 or opening may be formed as a cavity. Such cavity may be provided by forming a notch that increases its depth in a sloping manner beginning from the edges of the recess to the center of the recess / notch. According to a further variation of this embodiment, the deepest point may be any point or edge inside the recess / cavity.

**Fig. 3** illustrates a perspective view of circuit carrier 10 of the electronic module package comprising plural recesses 20 formed at the bottom side of the circuit carrier 10 according to an exemplary embodiment of the invention.

As exemplarily illustrated, the at least one recess 20 is formed as two separate recesses 20. If a plurality of recesses are formed, they may have different dimensions. As a further variation of this embodiment, each of the at least one recess or cavity 20 may provide a different depth of the circuit carrier 10. Furthermore, the plural recesses 20 may be separated by at least one bridge 30, which belongs to the surface of the circuit carrier 10, which has not been laser shaped or milled during fabricating the at least one recess 20.

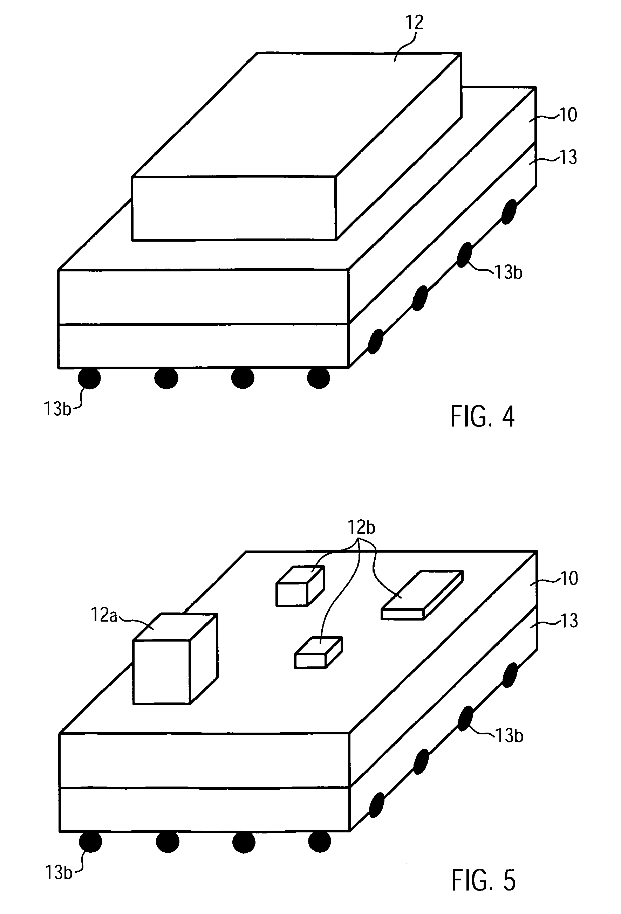

**Fig. 4** illustrates a perspective view of an electronic module package having mounted an antenna module as the at least one second electronic component 12 on top of the circuit carrier 10 according to another exemplary embodiment of the invention.

This figure shows the module package after mounting the circuit carrier 10 on top of the circuit board 13.

It is further shown that the electronic module package may be contacted by soldering contacts 13b, which may either be provided as a Ball- or-Land-Grid Array underneath the circuit board 13 of the module package or as side contacts at the bottom edges of the circuit board 13.

According to one further embodiment of the invention, one advantage of composing the module package by mounting providing carrier board 10 and circuit board 13 as separate boards is the possibility of providing outline and pin compatible construction kits for the module package. This may be advantageous in case of providing a construction kit for a plurality of GPS receiver. For instance, the receiver circuit may be provided at the circuit board 13, whereas a variety of antenna modules can easily be mounted at the circuit carrier 10. This implementation may provide the ability of replacing the antenna modules thereby allowing a flexible adjustment of GPS modules to, for instance, new requirements of the navigation device or the like the electronic antenna module package is implemented to.

Another advantage of the separation of board 10 and 13 may be the compatibility of products of different suppliers. For instance, if standardized dimensions of the circuit carrier 10 and circuit board 13 are employed, the resulting electronic module package may consist of boards of different manufacturers.

Even more, if the electronic module package is outline and pin compatible, it may be mountable to any motherboard or main printed circuit board 14 that provides compatible soldering contacts on its surface. Thereby, the main printed circuit board 14 may also origin from a different manufacturer.

It is further apparent from Fig. 4 that as an advantage of the above described arrangement of circuit carrier 10 and circuit board 13 inside the module package, the required size of the package's ground area is substantially defined by only the size of the at least one second electronic component 12 and the ground plane provided on top of the circuit carrier 10.

**Fig. 5** illustrates a perspective view of an electronic module package having mounted at least one sensor module together with electronic circuit components on top of the circuit carrier 10 according to another exemplary embodiment of the invention.

As an example, module 12a may be an acceleration sensor module that may be combined with a yaw rate sensor module additionally mounted on top of circuit carrier 10 so as to provide a module package employed for inertial navigation systems. According to another variation of this embodiment of the invention, further to the yaw rate sensor module and / or acceleration sensor module, there may additionally a GPS antenna module be mounted on top of circuit carrier 10.

As apparent from the description of the various embodiments of the invention provided above, the invention allows to significantly reduce the overall height of such electronic module package by employing the circuit carrier 10, which on the one hand is used as a fixture for the at least one second electronic component 12 mounted thereon, without the need of further additional mounting accessories. On the other hand, by providing a ground plane on the upper surface of the circuit carrier 10, no additional shielding measures have to be carried out such as an extra shielding cover on top of the electronic package module.

Consequently, the circuit carrier 10 according to the invention is a fixture and a spacer for electronic components such as antenna modules mounted on top of the circuit carrier 10 as well as simultaneously a shielding member for the electronic components received in the recess 20 of the circuit carrier 10.

Thus, the circuit carrier 10 as described in the embodiments of the invention replaces an extra shielding member for reducing electromagnetic interferences caused by or affected to the electronic components 15 mounted inside the recess 20 of the circuit carrier 10, and further replaces mounting accessories such as additional fixtures, plug-in connectors or mounting screws.

Hence, the costs for the module package itself as well as for the entire mounting process of such electronic module package can significantly be reduced.

It should be further noted that the individual features of the different embodiments of the invention may individually or in arbitrary combination be subject matter to another invention.

It would be appreciated by a person skilled in the art that numerous variations and/or modifications may be made to the present invention as shown in the specific embodiments without departing from the spirit or scope of the invention as broadly described. The present embodiments are, therefore, to be considered in all respects to be illustrative and not restrictive.

## Claims

1. A circuit carrier (10) which can be mounted on a circuit board (13), wherein the circuit board comprises at least one first electronic component (15) mounted and electrically connected to the circuit board, the circuit carrier comprising:
a first side having mounted thereon at least one second electronic component (12); and
a second side opposite to the first side, the second side comprising at least one recess (20) being adapted to receive the at least one first electronic component, when the circuit carrier is mounted on the circuit board;
wherein the at least one first electronic component remains exclusively contacted by the circuit board.

2. The circuit carrier according to claim 1, wherein the at least one recess spans substantially the surface of the second side of the circuit carrier.

3. The circuit carrier according to claim 1 or 2, wherein the circuit carrier is a printed circuit board and comprises a multi-layer structure.

4. The circuit carrier according to one of claims 1 to 3, wherein the circuit carrier further comprises an electromagnetic shielding element (10b) for electromagnetically shielding the at least one first electronic component received in the at least one recess, when the circuit carrier is mounted on the circuit board.

5. The circuit carrier according to claim 4, wherein the electromagnetic shielding element is provided at the first side of the circuit carrier or at one intermediate layer of the multi-layer structure of the circuit carrier.

6. The circuit carrier according to claim 4, wherein the electromagnetic shielding element is provided at the bottom surface of the at least one recess.

7. The circuit carrier according to one of claims 4 to 6, wherein the electromagnetic shielding element is implemented as a planar element for further serving as a ground plane for the at least one second electronic component mounted at the first side of the circuit carrier.

8. The circuit carrier according to one of claims 1 to 7, wherein the at least one recess is further adapted to provide a thermal isolation of the at least one first electronic component received in the at least one recess, when the circuit carrier is mounted on the circuit board.

9. The circuit carrier according to one of claims 1 to 8, wherein the at least one recess has a cavity shape.

10. The circuit carrier according to one of claims 1 to 9, wherein the circuit carrier is either single or double sided.

11. The circuit carrier according to one of claims 1 to 10, wherein the at least one second electronic component is at least one of:
- a GPS antenna module;
- an acceleration sensor module;
- a yaw rate sensor module; and
- a component for an electronic circuit.

12. An electronic module package (10, 12, 13, 15) comprising:
the circuit carrier (10) according to one of claims 1 to 11; and
the circuit board (13) having mounted the at least one first electronic component;
wherein the circuit carrier and the circuit board are mounted on top of each other, being electrically connected;
and wherein the at least one first electronic component is received in the at least one recess of the circuit carrier and remains exclusively contacted by the circuit board.

13. The electronic module package according to claim 12, further comprising electrical contacts (13b) for electrically connecting the electronic module package to a subjacent main circuit board (14).

14. The electronic module package according to claim 13, wherein the electrical contacts are realized as a Ball Grid-Array or as a Land Grid-Array being provided at the bottom side of the electrical module package.

15. The electronic module package according to claim 13, wherein the electrical contacts are provided on at least one side of the electronic package module.

16. The electronic module package according to one of claims 12 to 15, wherein the at least one second electronic component of the circuit carrier is electronically connected to the circuit board (13) by a through connection (11) within circuit carrier.

17. The electronic module package according to one of claims 12 to 16, wherein the at least one second electronic component is a GPS receiver module.

18. A method for manufacturing an electronic module package comprised of a circuit carrier and circuit board, wherein the circuit board comprises at least one first electronic component mounted and electrically connected to the circuit board, the method comprising the steps of:
assembling a first side of the circuit carrier with at least one second electronic component;
forming at least one recess at a second side of the circuit carrier, the second side being opposite to the first side; and
mounting the circuit carrier on the circuit board so that the at least one recess receives the at least one first electronic component of the circuit board;
wherein the at least one first electronic component remains exclusively contacted by the circuit board.

19. The method according to claim 18, wherein forming the at least one recess at the second side of the circuit carrier is carried out by at least one of:
- laser shaping;
- milling; and
- grouting plural pre-punched pre-impregnated fibres during manufacturing of the circuit carrier.

20. The method according to claim 18 or 19, further comprising the step of providing an electromagnetic shielding element at the first side of the circuit carrier or at one intermediate layer thereof.
